# EUROPEAN PATENT APPLICATION

(11) **EP 4 772 556 A1**
(43) Date of publication of application: **08.07.2026**
(21) Application number: 24859577.9
(22) Date of filing: 21.08.2024
(51) Int. Cl.: C08G 18/42, C08G 18/73, C08G 18/75, C09J 175/06

(54) **URETHANE COMPOSITION, CURED PRODUCT, IMPACT-RESISTANT ADHESIVE, AND POWER SEMICONDUCTOR SEALING AGENT**

(30) Priority: 29.08.2023 JP 2023138986
(71) Applicant: Daicel Corporation, Osaka-shi, Osaka 530-0011 (JP)
(72) Inventor: FUMIOKA, Akito, Tokyo 108-8230 (JP); MAETSU, Naritoshi, Tokyo 108-8230 (JP)
(74) Representative: Grünecker Patent- und Rechtsanwälte PartG mbB
(86) International application number: PCT/JP2024/029688
(87) International publication number: WO 2025/047544

(57) **Abstract**

The purpose of the present disclosure is to provide a urethane composition that can form a cured product that exhibits excellent tensile strength and elongation while having sufficient impact resistance. The urethane composition of the present disclosure contains an ester-based polyol and a polyisocyanate, wherein the ester-based polyol includes a structural moiety derived from an alicyclic diol compound, and no crystal melting peak is confirmed by DSC analysis. The polyisocyanate is preferably a non-aromatic isocyanate, and the polyisocyanate preferably contains a bifunctional isocyanate and a trifunctional isocyanate.

## Description

### Technical Field

The present disclosure relates to a urethane composition, a cured product, an impact-resistant adhesive, and a power semiconductor sealing agent. Moreover, the present application claims the rights of priority from JP 2023-138986 filed in Japan on August 29, 2023, the content of which is incorporated herein by reference.

### Background Art

A thermally conductive resin that is flexible and can conform to the shape of a heating element and adhere closely thereto is used as a method of dispersing (dissipating) to the outside, heat emitted from an electronic component or the like. As such a thermally conductive resin that excels in heat dissipation and adhesion to a heating element, use of a urethane-based composition containing a specific ester-based polyol, a polyisocyanate, and a filler is known (for example, Patent Document 1).

In addition, it is known that in a case in which an electronic component is used in a large device such as an automobile, excellent impact resistance is required in order to cope with external stimuli such as vibrations.

### Citation List

### Patent Document

Patent Document 1: JP 2020-533467 A

### Summary of Invention

### Technical Problem

However, in the invention of the urethane-based composition described in Patent Document 1, the ester-based polyol and the polyisocyanate that are used are easily crystallized, and a cured product thereof becomes too hard, and easily results in inferior impact resistance, which is a problem.

In addition, in order to solve the above problem, a large amount of a polyisocyanate having a specific structure must be used, but a known problem in this case is that the strength and elongation as a resin tend to become inferior.

Accordingly, an object of the present disclosure is to provide a urethane composition that can form a cured product that exhibits excellent tensile strength and elongation while maintaining sufficient impact resistance.

### Solution to Problem

As a result of intensive efforts to solve the above problems, the inventors of the present disclosure have discovered that a urethane composition containing an ester-based polyol and a polyisocyanate with the ester-based polyol including a specific structural moiety and the urethane composition having no crystal melting peak confirmed by differential scanning calorimetry (DSC) analysis, can form a cured product having excellent tensile strength and elongation while maintaining sufficient impact resistance. The inventors have arrived at the present disclosure on the basis of these findings.

That is, the present disclosure provides a urethane composition containing an ester-based polyol and a polyisocyanate, wherein the ester-based polyol includes a structural moiety derived from an alicyclic diol compound, and no crystal melting peak is confirmed by DSC analysis.

Because no crystal melting peak is observed in DSC analysis, the urethane composition is less likely to be excessively cured by crystallization and can thus exhibit impact resistance. In addition, by containing a structural moiety derived from an alicyclic diol compound in the ester-based polyol, a cured product excelling in both tensile strength and elongation can be achieved.

The polyisocyanate is preferably a non-aromatic polyisocyanate. Using a non-aromatic isocyanate facilitates handling.

The polyisocyanate preferably contains a bifunctional isocyanate and a trifunctional isocyanate. Through the above configuration, crystallization of the urethane composition is suppressed, and the cured product can easily exhibit impact resistance.

The blending amount of the trifunctional isocyanate in the polyisocyanate is preferably less than 45%. Through the above configuration, the tensile strength and elongation of the cured product can be easily improved.

The polyisocyanate preferably contains hexamethylene diisocyanate and a hexamethylene diisocyanate trimer.

The ester-based polyol is a polycaprolactone polyol and preferably has a number average molecular weight of from 400 to 800. Through the above configuration, crystallinity of the urethane composition can be reduced, and the impact resistance of the cured product can be easily exhibited.

The urethane composition preferably contains 1,4-cyclohexanedimethanol as the alicyclic diol compound.

The urethane composition is preferably of a two-component type.

The present disclosure also provides a cured product of the above urethane composition.

The present disclosure also provides an impact-resistant adhesive containing the cured product.

The present disclosure also provides a power semiconductor sealing agent containing the cured product.

### Advantageous Effects of Invention

The urethane composition of the present disclosure can form a cured product having excellent tensile strength and elongation while maintaining sufficient impact resistance.

### Description of Embodiments

### Urethane Composition

A urethane composition according to an embodiment of the present disclosure (hereinafter, may be referred to as a "urethane composition of the present disclosure") contains an ester-based polyol and a polyisocyanate, with the ester-based polyol containing a structural moiety derived from an alicyclic diol compound, and no crystal melting peak being confirmed by DSC analysis.

Since no crystal melting peak is confirmed by DSC analysis of the urethane composition according to an embodiment of the present disclosure, the urethane composition is less likely to be excessively cured by crystallization, and can thus exhibit impact resistance. In addition, by containing a structural moiety derived from an alicyclic diol compound in the ester-based polyol, a cured product excelling in both tensile strength and elongation can be achieved.

The viscosity at 25°C of the urethane composition according to an embodiment of the present disclosure is preferably 20000 mPa·s or less, more preferably 10000 mPa·s or less, even more preferably 1000 mPa·s or less, and still more preferably 500 mPa·s or less, and may be 300 mPa·s or less. When the viscosity is 20000 mPa·s or less, the urethane composition exhibits sufficient fluidity in a liquid state and excels in handling properties. Moreover, the lower limit of the viscosity thereof is not particularly limited, but is preferably 10 mPa·s or more, and more preferably 50 mPa·s or more. The viscosity is measured with an E-type viscometer, and when the urethane composition contains a filler, the viscosity is measured with a rheometer.

### Ester-based Polyol

The urethane composition according to an embodiment of the present disclosure contains an ester-based polyol, and the ester-based polyol contains a structural moiety derived from an alicyclic diol compound. In the urethane composition, the ester-based polyol contains the structural moiety derived from an alicyclic diol compound, and thereby the urethane composition is less likely to crystallize with the polyisocyanate, the blending amount of the belowdescribed polyisocyanate can be reduced, and excellent tensile strength and elongation of a cured product can be achieved. In the present disclosure, the term "ester-based polyol" means a compound having two or more hydroxyl groups, with the compound being obtained by polymerizing two or more monomer units having an ester bond in the molecule. In the urethane composition according to an embodiment of the present disclosure, a single type of the ester-based polyol may be used alone, or two or more types thereof may be used.

Examples of the ester-based polyol include a carboxylic acid-based polyol that is a condensation polymer of a polyhydric alcohol and a polycarboxylic acid, and a lactone-based polyol that is a ring-opening polymer of a cyclic ester (lactones). Among these, the ester-based polyol is preferably a lactone-based polyol derived from lactones using the alicyclic diol compound as an initiator. More specifically, the ester-based polyol is more preferably obtained by ring-opening polymerization of lactones using the alicyclic diol compound as an initiator.

Examples of the alicyclic diol compound include cyclohexanediols such as 1,2-cyclohexanediol, 1 3-cyclohexanediol, 1,4-cyclohexanediol, and 2-methyl-1,4-cyclohexanediol; cyclohexanedimethanols such as 1,2-cyclohexanedimethanol, 1,3-cyclohexanedimethanol, and 1,4-cyclohexanedimethanol; norbornane dimethanols such as 2,3-norbornane dimethanol and 2,5-norbornane dimethanol; and tricyclodecane dimethanol, pentacyclopentadecane dimethanol, 1,3-adamantanediol, 2,2-adamantanediol, decalindimethanol, 2,2,4,4- tetramethyl-1,3-cyclobutanediol, and isosorbide. The alicyclic diol compound is preferably a cyclohexanedimethanol, and is particularly preferably 1,4-cyclohexanedimethanol. A single type of the alicyclic diol compound may be used alone, or two or more types thereof may be used.

Specific examples of the lactones include lactones having from 4 to 20 carbons (preferably lactones having from 4 to 15 carbons, and more preferably lactones having from 4 to 10 carbons) such as β-propiolactone, β-butyrolactone, γ-butyrolactone, δ-valerolactone, δ-caprolactone, ε-caprolactone, γ-valerolactone, γ-caprolactone, γ-caprylolactone, γ-laurolactone, enantholactone, dodecanolactone, stearolactone, and alkyl-ε-caprolactones [for example, methyl-ε-caprolactones such as monomethyl-ε-caprolactones (such as α-methyl-ε-caprolactone, β-methyl-ε-caprolactone, and γ-methyl-ε-caprolactone), dimethyl-ε-caprolactones (such as β, δ-dimethyl-ε-caprolactone), and trimethyl-ε-caprolactones (such as 3,3,5-trimethyl-ε-caprolactone)], and ε-caprolactone is preferable. That is, the lactone-based polyol according to an embodiment of the present disclosure is preferably a polycaprolactone polyol. A single type of the lactone may be used alone, or two or more types thereof may be used.

The number average molecular weight of the ester-based polyol is not particularly limited, but is preferably from 400 to 800, more preferably from 450 to 750, and even more preferably from 500 to 700. When the number average molecular weight of the ester-based polyol is within the above range, excellent handling properties can be achieved.

The ester-based polyol is preferably a liquid at any one temperature within the range of room temperatures. In the present disclosure, "room temperature" means a temperature from 20 to 30°C.

### Polyisocyanate

The urethane composition according to an embodiment of the present disclosure contains a polyisocyanate. The polyisocyanate functions as a curable component in the urethane composition according to an embodiment of the present disclosure. In the urethane composition according to an embodiment of the present disclosure, a single type of the polyisocyanate may be used alone, or two or more types thereof may be used. In the present disclosure, the term "polyisocyanate" refers to a compound having two or more isocyanate groups (that is, a bifunctional or higher compound).

The polyisocyanate is preferably a non-aromatic polyisocyanate from the viewpoint of handling properties, and specifically, is more preferably an aliphatic polyisocyanate or an alicyclic polyisocyanate, and is particularly preferably an aliphatic polyisocyanate.

Moreover, from the viewpoint of reducing the crystallinity of the urethane composition, the polyisocyanate preferably includes a trifunctional or higher isocyanate, and from the viewpoint of exhibiting the tensile strength and elongation of the cured product, the polyisocyanate more preferably includes a bifunctional isocyanate and a trifunctional or higher isocyanate, and particularly preferably includes a bifunctional isocyanate and a trifunctional isocyanate.

Specific examples of the bifunctional isocyanate include aliphatic polyisocyanates such as tetramethylene diisocyanate, pentamethylene diisocyanate, hexamethylene diisocyanate, heptamethylene diisocyanate, octamethylene diisocyanate, nonamethylene diisocyanate, 2,2,4-trimethylhexamethylene diisocyanate, 2,4,4-trimethylhexamethylene diisocyanate, and decamethylene diisocyanate; and alicyclic polyisocyanates such as 1,3-cyclohexane diisocyanate, 1,4-cyclohexane diisocyanate, 1,3-bis(isocyanatomethyl)cyclohexane, 1,4-bis(isocyanatomethyl)cyclohexane, 4,4'-dicyclohexylmethane diisocyanate, isophorone diisocyanate, and norbornene diisocyanate.

Examples of the trifunctional or higher isocyanate include oligomers of the compounds exemplified above as bifunctional isocyanates, and in particular, the trifunctional or higher isocyanate is preferably a trimer of an above bifunctional isocyanate.

Among these, the urethane composition according to an embodiment of the present disclosure preferably contains hexamethylene diisocyanate and a hexamethylene diisocyanate trimer.

In addition, in a case in which the polyisocyanate contains a trifunctional isocyanate, the blending amount thereof in the total amount (100 mass%) of the polyisocyanate is preferably less than 45 mass%, more preferably 40 mass% or less, and even more preferably 35 mass% or less. When the blending amount of the trifunctional isocyanate is less than 45 mass%, a cured product that exhibits sufficient tensile strength and elongation can be easily obtained. In addition, trifunctional isocyanates are usually expensive, and therefore such a blending amount can reduce the cost. The lower limit of the blending amount thereof is preferably 5 mass% or more, and more preferably 10 mass% or more. When the blending amount of the trifunctional isocyanate is 5 mass% or more, crystallization of the urethane composition can be easily suppressed.

In the urethane composition according to an embodiment of the present disclosure, the ratio of the number of moles of isocyanate groups of the polyisocyanate to the number of moles of hydroxyl groups of the ester-based polyol, that is, the ratio of [NCO/hydroxyl groups], is within a range of preferably from 0.8 to 1.5, more preferably from 0.85 to 1.4, and still more preferably from 0.9 to 1.3. In other words, in the urethane composition according to an embodiment of the present disclosure, the ratio of the number of moles of structural moieties derived from isocyanate groups to the number of moles of structural moieties derived from hydroxyl groups other than those forming ester bonds in the ester-based polyol is preferably within the above range.

The urethane composition according to an embodiment of the present disclosure preferably contains a catalyst in order to promote the reaction between the ester-based polyol and the polyisocyanate. As the catalyst, a known or commonly used catalyst can be used, and examples thereof include an amine-based catalyst, an imidazole-based catalyst, and a metal catalyst. A single type of the above catalyst may be used alone, or two or more types may be used.

Examples of the above amine-based catalyst include triethylenediamine, 2-methyltriethylenediamine, N,N,N',N'-tetramethylethylenediamine, N,N,N',N'-tetramethylpropylenediamine, N,N,N',N",N"-pentamethyldiethylenetriamine, N,N,N',N",N"-pentamethyl-(3-aminopropyl)ethylenediamine, N,N,N',N",N"-pentamethyldipropylenetriamine, N,N,N',N'-tetramethylhexamethylenediamine, and bis(2-dimethylaminoethyl)ether.

Examples of the above imidazole-based catalyst include 1-methylimidazole, 1,2-dimethylimidazole, 1-isobutyl-2-methylimidazole, and 1-dimethylaminopropylimidazole.

Examples of the above metal catalyst include organotin catalysts such as stannous diacetate, stannous dioctoate, stannous dioleate, stannous dilaurate, dibutyltin oxide, dibutyltin diacetate, dibutyltin dilaurate, dibutyltin dichloride, and dioctyltin dilaurate.

The blending amount of the catalyst is preferably from 0.001 to 0.05 parts by mass, and more preferably from 0.005 to 0.03 parts by mass, per the total amount (100 parts by mass) of the resin components in the urethane composition.

The urethane composition according to an embodiment of the present disclosure may also contain a filler in order to ensure that sufficient heat dissipation properties are exhibited when the urethane composition is formed into a cured product. A single type of the filler may be used alone, or two or more types may be used.

As the filler, a known or commonly used filler can be used, and examples thereof include a metal filler, a carbon filler, and a metal oxide filler. Examples of the metal filler include metal fillers made of materials such as gold, silver, copper, nickel, palladium, tin, aluminum, or alloys thereof. The metal filler may be formed of a single type of metal, or may be formed of two or more types of metals, as in a core-shell structure, for example.

Examples of the shape of the filler include a spherical shape, an irregular shape, a flake shape (flat shape), a needle shape, a fiber shape, and a rod shape. The average particle size (median diameter) is preferably from 1 nm to 100 µm, more preferably from 10 nm to 50 µm, further preferably from 30 nm to 35 µm, and particularly preferably from 50 nm to 10 µm.

When the filler is contained, the blending amount thereof is preferably from 50 to 95 mass%, and more preferably from 60 to 90 mass%, per the total amount (100 mass%) of the urethane composition. When the blending amount of the filler is within the above range, heat dissipation properties are more easily exhibited.

### Other Components

The urethane composition according to an embodiment of the present disclosure may contain other components in addition to the ester-based polyol, the polyisocyanate, the catalyst, and the filler. Examples of the other components include polyols other than the ester-based polyol, light stabilizers, UV absorbers, antioxidants, solvents, flame retardants, pigments, antimicrobial agents, antistatic agents, processing aids, and viscosity enhancers. In relation to 100 mass% of the total amount of the urethane composition according to an embodiment of the present disclosure, the content of the other compounds is preferably 5 mass% or less, more preferably 3 mass% or less, still more preferably 1 mass% or less, and particularly preferably 0 mass%.

In addition, of the total amount (100 mass%) of polyols contained in the urethane composition according to an embodiment of the present disclosure, the blending amount of the ester-based polyol is preferably 90 mass% or more, more preferably 95 mass% or more, and even more preferably 100 mass%.

The urethane composition according to an embodiment of the present disclosure can be produced by mixing the above-described components by a known or commonly used method. In particular, the urethane composition according to an embodiment of the present disclosure is preferably a two-component type urethane composition in which the ester-based polyol is the main component and the polyisocyanate is mixed therewith as a curing agent.

### Cured Product

A cured product of the urethane composition can be produced by curing the urethane composition according to an embodiment of the present disclosure by a known or commonly used method. In particular, when the urethane composition according to an embodiment of the present disclosure is a two-component type urethane composition, the urethane composition may be cured by heating or may be cured at room temperature. In the case of curing by heating, the heating temperature is preferably from 25 to 150°C. Moreover, the curing time may be from 0.5 to 20 hours.

The A hardness of the cured product as measured in a state in which the thickness of the cured product is 6 mm or more is preferably from 50 to 69, more preferably from 55 to 68, and even more preferably from 60 to 67. When the A hardness is 69 or less, the cured product can easily exhibit impact resistance. In addition, when the A hardness is 50 or more, breakage of the cured product due to being too soft can be suppressed.

The tensile strength at break of the cured product as measured using a No. 3 dumbbell under conditions including a tensile speed of 500 mm/min and a distance between chucks of 60 mm is preferably 18 MPa or more, more preferably 20 MPa or more, and even more preferably 22 MPa or more. When the above tensile strength is 18 MPa or more, sufficient strength can be exhibited. In addition, the upper limit is not particularly limited, but is preferably 50 MPa or less.

The elongation at break as measured under the same conditions as the above tensile strength is preferably 300% or more, more preferably 350% or more, and still more preferably 400% or more. When the above elongation is 300% or more, elongation of the cured product can be sufficiently exhibited. In addition, the upper limit is not particularly limited, but is preferably 600% or less.

The shear adhesive strength of the cured product as measured in accordance with JIS K 6850 under conditions including a test speed of 5 mm/min and a distance between chucks of 112.5 mm using a test piece prepared by affixing Al substrates to each other is preferably 3.6 MPa or more, more preferably 3.8 MPa or more, and even more preferably 4.0 MPa or more. In addition, the upper limit is not particularly limited, but is preferably 10 MPa or less.

Moreover, the shear adhesive strength of the cured product as measured in accordance with JIS K 6850 under conditions including a test speed of 5 mm/min and a distance between chucks of 112.5 mm using a test piece prepared by affixing an Al substrate and a PET substrate to each other is preferably 2.0 MPa or more, and more preferably 2.5 MPa or more. In addition, the upper limit is not particularly limited, but is preferably 10 MPa or less.

The cured product is cured under the conditions indicated in the examples described below, and no crystal melting peak is observed using a differential scanning calorimeter when the cured product is heated at a temperature controlled rate of 10°C/min. By configuring the cured product such that no crystal melting peak is confirmed, excessive curing is suppressed when the composition is formed into a cured product, and impact resistance can be exhibited.

The cured product exhibits sufficient impact resistance and is excellent in tensile strength and elongation, and therefore can be used as an impact-resistant adhesive, and in particular, the cured product can be suitably used as an impact-resistant adhesive for use in a large device that is subject to large vibrations, such as an automobile or an aircraft. Moreover, the cured product has heat dissipation properties, and thus can be suitably used as a sealing agent for a power semiconductor that has high output and generates a large amount of heat.

Each aspect disclosed in the present specification can be combined with any other feature disclosed in the present specification. Moreover, each of the configurations in each of the embodiments, combinations thereof, and the like are merely examples, and various additions, omissions, and other modifications of the configurations may be made, as appropriate, without departing from the scope of the present disclosure. The present disclosure is not limited by the embodiments and is limited only by the claims.

### Examples

Hereinafter, an embodiment of the present disclosure will be described in more detail based on examples.

### Example 1

Amounts of 128.21 g of 1,4-cyclohexanedimethanol-modified polycaprolactone diol (Mw: 530), 36.19 g of hexamethylene diisocyanate (HDI) (trade name "HDI", available from Tosoh Corporation), 15.61 g of an HDI trimer (trade name "Duranate TKA-100", available from Asahi Kasei Corporation) (HDI trimer content: 30 mass%), and 0.018 g of dibutyltin dilaurate (DBTDL) were weighed in a cup for stirring, and then vacuum defoamed and stirred for 60 seconds using a vacuum defoaming stirrer (trade name "Vacuum Awatori Rentaro", available from Thinky Corporation), and a urethane composition of Example 1 was thereby prepared. The urethane composition was cast into a casting mold prepared by sandwiching a silicon spacer between glass plates. After casting, the composition was cured for 16 hours or longer in a Geer oven set to 30°C, and after curing, the composition was released from the glass mold and aged for 2 days or longer to obtain a cured product. The thickness of the cured product that was prepared was 2 mm.

### Example 2

Amounts of 124.45 g of 1,4-cyclohexanedimethanol-modified polycaprolactone diol (Mw: 530), 30.76 g of HDI (trade name "HDI", available from Tosoh Corporation), 24.79 g of an HDI trimer (trade name "Duranate TKA-100", available from Asahi Kasei Corporation) (HDI trimer content: 45 mass%), and 0.018 g of dibutyltin dilaurate (DBTDL) were weighed in a cup for stirring, and then vacuum defoamed and stirred for 60 seconds using a vacuum defoaming stirrer (trade name "Vacuum Awatori Rentaro", available from Thinky Corporation), and a urethane composition of Example 2 was thereby prepared. Moreover, a cured product of Example 2 was prepared in the same manner as in Example 1.

### Comparative Example 1

Amounts of 113.75 g of 1,4-BG-modified polycaprolactone diol (Mw: approximately 400), 36.69 g of HDI (trade name "HDI", available from Tosoh Corporation), 29.57 g of an HDI trimer (trade name "Duranate TKA-100", available from Asahi Kasei Corporation) (HDI trimer content: 45 mass%), and 0.018 g of dibutyltin dilaurate (DBTDL) were weighed in a cup for stirring, and then vacuum defoamed and stirred for 60 seconds using a vacuum defoaming stirrer (trade name "Vacuum Awatori Rentaro", available from Thinky Corporation), and a urethane composition of Comparative Example 1 was thereby prepared. Moreover, a cured product of Comparative Example 1 was prepared in the same manner as in Example 1.

### Comparative Example 2

Amounts of 117.87 g of 1,4-BG-modified polycaprolactone diol (Mw: approximately 400), 43.41 g of HDI (trade name "HDI", available from Tosoh Corporation), 18.72 g of an HDI trimer (trade name "Duranate TKA-100", available from Asahi Kasei Corporation) (HDI trimer content: 30 mass%), and 0.018 g of dibutyltin dilaurate (DBTDL) were weighed in a cup for stirring, and then vacuum defoamed and stirred for 60 seconds using a vacuum defoaming stirrer (trade name "Vacuum Awatori Rentaro", available from Thinky Corporation), and a urethane composition of Comparative Example 2 was thereby prepared. Moreover, a cured product of Comparative Example 2 was prepared in the same manner as in Example 1.

### Evaluation

The urethane compositions and their cured products obtained in the examples and comparative examples were evaluated as follows, and the results are shown in Table 1.

### (1) Viscosity

The viscosity at 25°C of the urethane compositions of the examples and comparative examples was measured using an E-type viscometer.

### (2) A Hardness

For each of the examples and comparative examples, three sheets of the cured product were stacked to a thickness of 6 mm or more, and the A hardness was measured using a durometer (trade name "GS-610", available from Teclock Co., Ltd.).

### (3) Tensile Strength and Elongation

For each of the examples and comparative examples, a No. 3 dumbbell test piece was cut out from the cured product using a dumbbell cutter, and the test piece was subjected to a tensile test using a tensile tester (trade name "RTC-1350A", available from A&D Co., Ltd.) at a tensile speed of 500 mm/min and a distance between chucks of 60 mm to thereby measure the tensile strength and elongation at the time of fracture of the cured product.

### (4) Shear Adhesive Strength

For each of the examples and comparative examples, the urethane composition was spread onto Al substrates or onto an AI substrate and a PET substrate based on the test piece dimensions specified in JIS K 6850, and the Al substrates were bonded to each other or the Al substrate and the PET substrate were bonded to each other. The specimen was cured in a Geer oven at 30°C for 16 hours or longer, and a test piece was thereby obtained. The tensile shear adhesive strength of the obtained test piece was measured using a tensile tester (trade name "RTC-1350A", available from A&D Co., Ltd.) at a test speed of 5 mm/min and a distance between chucks of 112.5 mm.

### (5) Presence or Absence of Crystal Melting Peak

For each of the examples and comparative examples, the cured product was heated at a controlled temperature rate of 10°C/min using a differential scanning calorimeter (trade name "DSC Q-2000", available from TA Instruments), and the presence or absence of a crystal melting peak of the crystalline component was measured.

### [Table 1]

**Table 1**

| | Example 1 | Example 2 | Comparative Example 1 | Comparative Example 2 |
|---|---|---|---|---|
| Viscosity (mPa·s, 25°C) | 167.3 | - | 91 | - |
| A Hardness | 64 to 66 | 67 | 70 to 79 | - |
| Tensile Strength (MPa) | 24 | 8.5 | 16 | 39 |
| Elongation (%) | 420 | 190 | 290 | 250 |
| Shear Adhesive Strength (Al/Al) (MPa) | 4.1 | - | 3.5 | - |
| Shear Adhesive Strength (Al/PET) (MPa) | 2.7 | - | 3.4 | - |
| Crystal Melting Peak | absent | absent | absent | present |

In the urethane compositions of the examples, the ester-based polyol contained a structural moiety derived from an alicyclic diol, and therefore the addition amount of polyisocyanate could be suppressed, and excellent tensile strength and elongation of the cured product were successfully achieved. In addition, no crystal melting peaks were observed by DSC analysis, and therefore the presence of impact resistance was confirmed. On the other hand, when the ester-based polyol did not contain a structural moiety derived from an alicyclic diol, a large amount of polyisocyanate was required to suppress the hardness, suggesting that the tensile strength and elongation of the cured product were inferior (Comparative Example 1). In addition, when a crystal melting peak was confirmed, the hardness increased, suggesting that the impact resistance was poor (Comparative Example 2).

Hereinafter, variations of the present disclosure will be described.

### [Appendix 1]

A urethane composition containing an ester-based polyol and a polyisocyanate wherein,
the ester-based polyol includes a structural moiety derived from an alicyclic diol compound, and
no crystal melting peak is confirmed by DSC analysis.

### [Appendix 2]

The urethane composition according to appendix 1, wherein a viscosity at 25°C is 20000 mPa·s or less.

### [Appendix 3]

The urethane composition according to appendix 1 or 2, wherein the viscosity at 25°C is 10 mPa·s or more.

### [Appendix 4]

The urethane composition according to any one of appendices 1 to 3, wherein the polyisocyanate is a non-aromatic polyisocyanate.

### [Appendix 5]

The urethane composition according to any one of appendices 1 to 4, wherein the polyisocyanate contains a bifunctional isocyanate and a trifunctional isocyanate.

### [Appendix 6]

The urethane composition according to appendix 5, wherein a blending amount of the trifunctional isocyanate in the polyisocyanate is less than 45 mass%.

### [Appendix 7]

The urethane composition according to any one of appendices 1 to 6, wherein the polyisocyanate contains hexamethylene diisocyanate and a hexamethylene diisocyanate trimer.

### [Appendix 8]

The urethane composition according to any one of appendices 1 to 7, wherein the ester-based polyol is a polycaprolactone polyol and has a number average molecular weight of from 400 to 800.

### [Appendix 9]

The urethane composition according to any one of appendices 1 to 8, containing 1,4-cyclohexanedimethanol as the alicyclic diol compound.

### [Appendix 10]

The urethane composition according to any one of appendices 1 to 9, further containing a catalyst.

### [Appendix 11]

The urethane composition according to any one of appendices 1 to 10, further containing a filler.

### [Appendix 12]

The urethane composition according to any one of appendices 1 to 11, wherein the urethane composition is of a two-component type.

### [Appendix 13]

A cured product of the urethane composition described in any one of appendices 1 to 12.

### [Appendix 14]

The cured product according to appendix 13, wherein the cured product has an A hardness of from 50 to 69 as measured in a state of being formed to have a thickness of 6 mm or more.

### [Appendix 15]

The cured product according to appendix 13 or 14, wherein the cured product has a tensile strength at break of 18 MPa or more as measured using a No. 3 dumbbell under conditions including a tensile speed of 500 mm/min and a distance between chucks of 60 mm.

### [Appendix 16]

The cured product according to any one of appendices 13 to 15, wherein the cured product has an elongation at break of 300% or more as measured using a No. 3 dumbbell under conditions including a tensile speed of 500 mm/min and a distance between chucks of 60 mm.

### [Appendix 17]

The cured product according to any one of appendices 13 to 16, wherein the cured product has a shear adhesive strength of 3.6 MPa or more as measured in accordance with JIS K 6850 under conditions including a test speed of 5 mm/min and a distance between chucks of 112.5 mm using a test piece prepared by affixing Al substrates to each other.

### [Appendix 18]

The cured product according to any one of appendices 13 to 17, wherein the cured product has a shear adhesive strength of 2.0 MPa or more as measured in accordance with JIS K 6850 under conditions including a test speed of 5 mm/min and a distance between chucks of 112.5 mm using a test piece prepared by affixing an Al substrate and a PET substrate to each other.

### [Appendix 19]

An impact-resistant adhesive containing the cured product described in any one of appendices 13 to 18.

### [Appendix 20]

A power semiconductor sealing agent containing the cured product described in any one of appendices 13 to 18.

## Claims

1. A urethane composition comprising an ester-based polyol and a polyisocyanate, wherein
the ester-based polyol includes a structural moiety derived from an alicyclic diol compound, and
no crystal melting peak is confirmed by DSC analysis.

2. The urethane composition according to claim 1, wherein the polyisocyanate is a non-aromatic polyisocyanate.

3. The urethane composition according to claim 1 or 2, wherein the polyisocyanate contains a bifunctional isocyanate and a trifunctional isocyanate.

4. The urethane composition according to claim 3, wherein a blending amount of the trifunctional isocyanate in the polyisocyanate is less than 45 mass%.

5. The urethane composition according to claim 1 or 2, wherein the polyisocyanate contains hexamethylene diisocyanate and a hexamethylene diisocyanate trimer.

6. The urethane composition according to claim 1 or 2, wherein the ester-based polyol is a polycaprolactone polyol and has a number average molecular weight of from 400 to 800.

7. The urethane composition according to claim 1 or 2, comprising 1,4-cyclohexanedimethanol as the alicyclic diol compound.

8. The urethane composition according to claim 1 or 2, wherein the urethane composition is of a two-component type.

9. A cured product of the urethane composition described in claim 1 or 2.

10. An impact-resistant adhesive comprising the cured product described in claim 9.

11. A power semiconductor sealing agent comprising the cured product described in claim 9.
